(19) **Europäisches Patentamt / European Patent Office / Office européen des brevets**

(11) **EP 3 519 448 B1**

(12) **FASCICULE DE BREVET EUROPEEN**

(45) Date de publication et mention de la délivrance du brevet:
**15.06.2022 Bulletin 2022/24**

(21) Numéro de dépôt: **17786959.1**

(22) Date de dépôt: **27.09.2017**

(51) Classification Internationale des Brevets (IPC):
**C08F 2/44** *(2006.01)*          **B29C 35/00** *(2006.01)*
**B29C 67/00** *(2017.01)*          **C08F 2/46** *(2006.01)*
**C08G 59/00** *(2006.01)*          **C08L 51/00** *(2006.01)*
**C08L 71/02** *(2006.01)*          **G03F 7/20** *(2006.01)*
**G03F 7/26** *(2006.01)*

(52) Classification Coopérative des Brevets (CPC):
**C08F 2/46; B29C 64/124; B29C 64/165;**
**B33Y 70/00; C08F 2/44; G03F 7/0037;**
**G03F 7/0047; G03F 7/027; G03F 7/031;**
**G03F 7/038; G03F 7/2053; G03F 7/70416;**
B29C 2035/0838

(86) Numéro de dépôt international:
**PCT/FR2017/052622**

(87) Numéro de publication internationale:
**WO 2018/060617 (05.04.2018 Gazette 2018/14)**

(54) **PROCÉDÉ POUR LA RÉALISATION D'UN OBJET TRIDIMENSIONEL PAR UN PROCESSUS DE PHOTO-POLYMÉRISATION MULTI-PHOTONIQUE ET DISPOSITIF ASSOCIÉ**

VERFAHREN ZUR HERSTELLUNG EINER 3D-STRUKTUR DURCH MULTIPHOTONISCHE POLYMERISATION UND DAZU PASSENDE VORRICHTUNG

PROCESS TO PREPARE A 3D-OBJECT VIA MULTI-PHOTONIC POLYMERISATION AND RELATED DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.09.2016 FR 1659211**

(43) Date de publication de la demande:
**07.08.2019 Bulletin 2019/32**

(73) Titulaires:
• **Ecole Centrale de Marseille**
  **13013 Marseille (FR)**
• **Universite d'Aix-Marseille**
  **13007 Marseille (FR)**
• **Centre National de la Recherche Scientifique**
  **75016 Paris (FR)**

(72) Inventeurs:
• **ANDRE, Jean-Claude**
  **54000 Nancy (FR)**
• **GALLAIS-DURING, Laurent**
  **84120 Pertuis (FR)**
• **AMRA, Claude**
  **13013 Marseille (FR)**

(74) Mandataire: **Croonenbroek, Thomas Jakob**
**Innovincia**
**310 avenue Berthelot**
**69008 Lyon (FR)**

(56) Documents cités:
**EP-A2- 1 085 352          US-A1- 2011 006 459**
**US-A1- 2013 056 910**

Remarques:
Le dossier contient des informations techniques présentées postérieurement au dépôt de la demande et ne figurant pas dans le présent fascicule.

**Description**

La présente invention concerne un procédé de réalisation d'un objet tridimensionnel et un dispositif pour la mise en œuvre de ce procédé.

Les technologies d'impression 3D ont connu un engouement considérable depuis leurs premières utilisations au milieu des années 80.

On connait notamment du brevet FR 2 567 668 un dispositif pour la réalisation de modèles de pièces industrielles. Ce dispositif permet de réaliser des pièces par balayages de plans successifs horizontaux, le balayage s'effectuant du bas vers le haut de la cuve contenant le liquide monomère.

Les techniques d'impression 3D ou impression tridimensionnelle couramment utilisées se basent sur un principe similaire, c'est-à-dire que l'objet est obtenu séquentiellement par la superposition de couches ou par apport séquentiel de matière.

Parmi les différents procédés d'impression 3D, on distingue plus particulièrement le FDM (Fused Deposition Modeling : modelage par dépôt de matière en fusion), la SLA (Stéréo-lithographie) et le frittage sélectif par laser (un laser agglomère une couche de poudre).

Ces techniques ont été considérablement améliorées au cours de ces dernières années de sorte qu'elles ne sont plus seulement utilisées pour la réalisation de prototypes, mais de plus en plus souvent pour la réalisation d'objets fonctionnels.

La stéréo-lithographie par photo-polymérisation est une technique d'impression 3D qui permet de fabriquer un objet tridimensionnel par une succession de couches de résine photo-polymérisable. L'objet est fabriqué dans un bain de résine liquide, la résine étant généralement polymérisée par polymérisation radicalaire à partir d'une composition de monomères acrylates ou par polymérisation cationique à partir d'une composition époxy et d'un photo-initiateur ou photo-amorceur, qui permet la polymérisation sous l'effet d'une irradiation lumineuse. Certaines compositions adaptées aux applications de stéréo-lithographie à un photon sont disponibles dans le commerce. Ces compositions comprennent des monomères, typiquement des acrylates ou des époxys et l'amorceur.

Une plateforme mobile est plongée généralement dans une cuve de résine liquide et supporte l'objet en cours de fabrication. La plateforme est positionnée à une certaine profondeur en dessous du niveau de la résine.

Un faisceau laser est dirigé sur la surface de la résine liquide pour réaliser un balayage adapté afin de photo-polymériser la résine et de former une tranche de l'objet à fabriquer.

Après le traitement d'une tranche, la plateforme descend d'une distance prédéfinie correspondant à l'épaisseur d'une tranche et le processus se renouvelle pour chaque tranche, permettant ainsi l'obtention de la structure complète en 3D de l'objet. Une fois terminée, l'objet est retiré de la cuve, lavé et les éléments de maintien éliminés mécaniquement. La résine liquide non polymérisée présente dans la cuve, peut par la suite être récupérée.

Selon la résine utilisée, une dernière étape de cuisson de l'objet peut être appliquée afin de le durcir.

Ces techniques ont pour inconvénient de ne pas permettre la réalisation de couches très fines, typiquement de l'ordre de quelques dizaines de $\mu$m voire inférieures au $\mu$m, lesquelles présentent le risque de se déplacer ou d'être arrachées lors de la fabrication de l'objet.

Par ailleurs, ces techniques d'impression 3D par superposition de couches, ne permettent pas la fabrication d'objets complexes ou nécessitant un degré élevé de finition. Ceci est notamment dû à la viscosité de la résine et à sa tension superficielle. En règle générale, une résine de faible viscosité, généralement de l'ordre de quelques dizaines ou centaines de cP (centi-Poise), est préférée, car elle facilite la mise en place des couches.

A ceci s'ajoute le fait qu'il faut également fabriquer des éléments de maintien comme un/des support(s), par exemple des tiges, qui vont être supprimés une fois que l'objet est retiré de la résine afin de maintenir l'objet en construction dans la cuve.

Ces éléments de maintien s'avèrent nécessaires du fait de la faible viscosité de la résine et de sa nature liquide. Un objet créé dans une résine de faible viscosité et sans éléments de maintien ou support aurait tendance à se déplacer (ne serait-ce que lors de l'ajout d'une couche de résine), ce qui rend la fabrication de l'objet difficile, voire impossible.

Selon la complexité de l'objet à réaliser, certains de ces supports ne peuvent être retirés aisément et, dans certains cas, l'objet ne peut pas être fabriqué. La réalisation d'éléments de maintien ou d'appendices de fabrication dont le seul but est de permettre la fabrication de l'objet augmente davantage le temps de conception, de fabrication et de finition.

Par ailleurs, pour des objets nécessitant un aspect de surface fini, il est nécessaire d'utiliser une résolution de fabrication adaptée à l'état de surface souhaité ou de réaliser un traitement complémentaire comme de l'usinage.

Afin de s'affranchir de ces limitations, il est possible de recourir à des techniques de photo-polymérisation multi-photonique(SL2P), notamment à deux photons.

Des techniques de photo-polymérisation à deux photons ont, par exemple, été développées par Shoji Maruo, Osamu Nakamura, and Satoshi Kawata, "Three-dimensional microfabrication with two-photon-absorbed photopolymerization," Opt. Lett. 22, 132-134 (1997).

Ces techniques consistent à atteindre directement, à l'aide d'un pointeur optique avantageusement formé par un faisceau laser focalisé, un endroit désigné dans un volume afin de polymériser la résine à cet endroit. Un objet peut ainsi être fabriqué en continu en dirigeant le faisceau laser focalisé dans le volume de la cuve contenant la composition sans qu'il soit nécessaire de fabriquer l'objet par tranches ou couches successives.

La réalisation d'objets en 3D par photo-polymérisation multi-photonique permet ainsi de réaliser des objets de grande complexité avec un degré élevé de finition, pouvant être de l'ordre du nanomètre.

Ces techniques d'impression SL2P nécessitent l'utilisation d'amorceurs capables d'absorber deux photons de façon séquentielle ou simultanée afin de former des espèces réactives permettant d'amorcer la polymérisation.

L'absorption à deux photons nécessitant, selon le matériau, une densité lumineuse importante, de l'ordre d'une centaine de mJ/cm$^2$ au point focal, la photo-polymérisation est limitée au voisinage immédiat du point focal du laser, là où la densité lumineuse est assez importante pour activer l'amorceur.

L'un des principaux avantages de la stéréo-lithographie à deux photons (SL2P) est de permettre la fabrication d'objets tridimensionnels sans nécessiter de fabriquer l'objet en tranches ou couches superposées.

Cette résolution fixe est définie par la dimension du volume élémentaire, ou voxel, produit par impulsion laser. Le voxel est l'acronyme de « volumetric pixel », c'est-à-dire pixel volumétrique en français. Si l'on souhaite disposer d'une bonne résolution sans traitement complémentaire, lorsque l'objet à fabriquer nécessite une résolution élevée, cela conduit à des temps de fabrication très longs et des coûts d'exploitations possiblement prohibitifs. C'est pourquoi cette technique de SL2P est généralement limitée à des objets de petite taille, souvent dans le domaine millimétrique, voir micro- ou nanométrique.

De plus, cette technique nécessite d'utiliser une densité lumineuse importante au niveau du point focal qui est généralement de taille micrométrique et qui n'est donc pas optimisé pour la fabrication d'objets centimétriques, c'est-à-dire inscrit dans un volume compris typiquement entre environ 1 et 1000 cm$^3$.

Plus récemment des techniques de SLP2 à résolution variable ont été développées. On connait du document « Stereolithography with variable resolutions using optical filter with high contrast-gratings » Li et Al, J. Vac. Sci. Technol. B, Vol. 33, No 6, Nov/Dec 2015 une méthode d'impression 3D par stéréo-lithographie. La variation de la résolution étant obtenue par l'utilisation de filtres optiques modifiant la longueur d'onde du faisceau laser, permettant une taille de pixel variable de 37 et 417 $\mu$m. Cette méthode a pour inconvénient d'utiliser 2 longueurs d'onde différentes et donc de ne permettre que 2 tailles de pixels en fonction de la longueur d'onde du faisceau laser et du filtre optique. Par ailleurs cette technique reste seulement adaptée à des objets de taille micrométrique.

Le document « using variable beam spot scanning to improve the SL process » Yi et al, Rapid Prototyping Journal, Vol. 19, No 2, 2013, pages 100-110, décrit une méthode de stéréo-lithographie à résolution variable. La variation de la résolution étant obtenue par un dispositif optique. Cette méthode permet de former des objets de taille centimétrique. Toutefois cette méthode présente de nombreux inconvénients et nécessite une optimisation importante du dispositif en fonction des objets à réaliser. Bien qu'il soit possible avec ce procédé de changer la taille du voxel en deux dimensions, cela n'est pas possible dans la troisième dimension, perpendiculaire aux deux premières, par exemple en profondeur.

Plus récemment, des procédés dit de bio-impression ont été développés pour la fabrication de tissus vivants, voire d'organes. Ces méthodes sont notamment décrites dans les publications suivantes.

- André J.C., Malaquin L., Guédon E. (2017) « Bio-printing ; où va-t-on ? » Techniques de l'Ingénieur - ref. RE268 V1, 23pp. (2017). ;

- Chua C.K., Yeong N.Y. (2015) "Bio-printing: principles and applications" e-book World Scientific Ed. - Singapour.

- Morimoto Y., Takeuchi S. (2013) "3D cell culture based on microfluidic technique to mimic living tissues" Biomatter. Sci., 1, 257-264.

Ces procédés de bio-impression sont des procédés de fabrication additive à partir de cellules vivantes associées à des supports fabriqués par exemple en stéréo-lithographie.

L'un des inconvénients de ces procédés est qu'ils engendrent des mouvements de cisaillement lors de la mise en place des couches successives, or ces mouvements sont susceptibles d'endommager les cellules vivantes et d'affecter leur survie.

La présente invention vise à pallier au moins partiellement les différents inconvénients précités en proposant un procédé d'impression en trois dimensions utilisant la photo-polymérisation multi-photonique (SL2P), notamment à deux photons, qui soit plus efficace pour la réalisation d'objets de taille centimétrique.

A cet effet, la présente invention propose un procédé de réalisation d'un objet tridimensionnel comprenant les opérations suivantes:

a. introduire une composition dans une cuve de polymérisation,

b. polymériser par photo-polymérisation multi-photonique, à des endroits prédéterminés, la composition pour réaliser l'objet tridimensionnel, la composition comprenant au moins un monomère, au moins une charge et au moins un photo-amorceur,

- caractérisée en ce que : la différence entre les indices de réfraction du monomère et de la charge présente est inférieure à 0.05 ;

- la viscosité de la composition est supérieure ou égale à 0.05 Pa.s ;

- la composition est transparente à la longueur d'onde de photo-polymérisation.

Après la réalisation de l'objet tridimensionnel, ce dernier est retiré de la cuve et lavé dans une solution permettant d'éliminer de l'objet tridimensionnel la composition non polymérisée. La solution étant par exemple de l'isopropanol et/ou de l'acétone.

Grâce à l'invention, on gagne de manière significative en efficacité pour réaliser des objets centimétriques. De plus, on peut s'affranchir d'artefacts de fabrication, c'est à dire de la réalisation d'éléments ou d'appendices de maintien ou de supports devant être supprimés une fois l'objet tridimensionnel terminé.

Le procédé selon l'invention peut, en outre, présenter une ou plusieurs des caractéristiques suivantes prises seules ou en combinaison :

- la composition a une valeur de viscosité supérieure ou égale à 0.30 Pa.s,

- la charge comprend des particules transparentes,

- la composition comprend de 10 à 70 % en volume de particules transparentes,

- les particules transparentes sont de forme sphérique,

- les particules transparentes sont réalisées en silice, en verre, notamment du verre borosilicate ou du verre sodo-calcique,

- les particules transparentes sont réalisées en matériau organique, notamment avec des polymères insolubles dans la résine,

- la charge comprend au moins un composant soluble dans la composition,

- la composition comprend des monomères choisis parmi l'acide L-lactique, de l'acide glycolique, des capro-lactones, considérés seuls ou en mélange, des charges comprenant des cellules vivantes, un hydrogel choisi parmi le collagène, la gélatine, la fibrine, l'alginate, la chitine, le chitosane, l'acide hyaluronique, le (poly-(2-hydroxyethyl méthacrylate) (PHEMA), l'alcool polyvinylique (PVA) et le poly-éthylèneglycol (PEG) considérés seuls ou en mélange,

- le monomère est un monomère acrylique,

- le monomère acrylique est choisi parmi le groupe suivant : du poly-(éthylène glycol)-diacrylate, du tri(ethylène glycol)-dimethacrylate, du pentaerythritol-tetracrylate, du 1,6-hexanediol-diacrylate, ou en combinaison,

- le ou les photo-amorceurs sont choisis dans le groupe suivant : cétones aromatiques, des dérivés aromatiques, de l'éosine Y et autres colorants xanthéniques,

- la composition comprend au moins un monomère époxy,

- le photo-amorceur est un sel d'onium,

- on réalise la photo-polymérisation multi-photonique à l'aide d'un faisceau laser, caractérisé en ce que l'on adapte la résolution spatiale de polymérisation en plaçant un diffuseur optique, notamment entre 1° et 20°, dans le faisceau laser,

- l'objet tridimensionnel comprend une surface externe et un volume interne et dans lequel on polymérise des endroits localisés dans le volume interne avec une résolution plus faible que les endroits formant la (les) surface(s) externe(s) de l'objet tridimensionnel,

- différentes portions de l'objet tridimensionnel sont successivement polymérisés dans différentes cuves contenant chacune une composition spécifique permettant d'obtenir une taille de voxel, voire des fonctionnalités prédéterminées,

- le volume interne est polymérisé dans une première cuve contenant une première composition comprenant des premières charges sous forme de particules transparentes permettant d'obtenir une première taille de voxel et la partie externe de l'objet est polymérisé dans une deuxième cuve contenant une seconde composition comprenant des deuxième charges sous forme de particules transparentes ou aucune charge permettant d'obtenir une seconde taille de voxel, inférieure à la première taille de voxel.

Selon un autre mode de réalisation, l'invention peut être adaptée pour des opérations de bio-impression.

L'utilisation du procédé selon l'invention présente l'avantage de ne pas engendrer de mouvement de cisaillement améliorant ainsi les procédés de bio printing. De surcroît, les cellules sont moins sensibles aux rayonnements de grande longueur d'onde, typiquement de l'ordre de 300 à 360 nm pour des procédés d'impression conventionnels et de l'ordre de 550 nm pour des technologies de SL2P, ce qui permet d'autoriser une meilleure survie des éléments vivants présent dans une composition organique biocompatible photo-polymérisable.

L'invention concerne également un dispositif de réalisation d'un objet tridimensionnel par photo-polymérisation multi-photonique, notamment à deux photons comprenant :

- un laser émettant un faisceau laser,

- une cuve de polymérisation destinée à recevoir une composition telle que décrite ci-dessus,

- un dispositif de focalisation du faisceau laser et d'adaptation de son ouverture numérique,

- une unité de déplacement pour permettre la focalisation du faisceau laser à l'intérieur de la cuve de polymérisation en vue de polymériser la composition aux endroits prédéterminés pour réaliser l'objet tridimensionnel,

- un adaptateur de résolution de polymérisation comprenant au moins un diffuseur monté mobile sur un support pour être placé sur le chemin optique ou en dehors du faisceau laser afin d'adapter la résolution de polymérisation.

D'autres avantages et caractéristiques apparaîtront à la lecture de la description de l'invention, ainsi que des figures suivantes sur lesquelles :

- la figure 1 est un schéma simplifié d'un montage d'un système de réalisation d'un objet tridimensionnel,

- la figure 2 est une vue schématique en détail d'une composition utilisée pour la réalisation d'un objet tridimensionnel,

- la figure 3 montre sur un tableau une liste non-exhaustive de monomères pouvant être utilisés dans la composition de l'invention,

- la figure 4 montre un tableau de photo-amorceurs pouvant être utilisés dans la composition de l'invention,

- la figure 5 montre un mécanisme classique de polymérisation ionique avec des étapes amorçage, propagation et transfert,

- la figure 6 montre un schéma de monomères multifonctionnels de systèmes réticulés, insolubles dans une résine initiale,

- les figures 7A et 7B sont des photographies représentant respectivement des voxels obtenus dans le cas d'un faisceau gaussien d'une part, et des voxels obtenus en plaçant un diffuseur en entrée de l'objectif pour contrôler la profondeur de champ du faisceau gaussien d'autre part, les deux figures 3A et 3B étant de même échelle,

- la figure 8 est un schéma pour permettre d'illustrer le procédé de réalisation d'un objet tridimensionnel selon un mode de réalisation.

- la figure 9 est un graphique représentant la mesure du diamètre du faisceau en fonction de la distance par rapport à l'objectif dans le cas de l'objectif seul et dans le cas de diffuseur 1° et 10°.

Sur toutes les figures, les éléments identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées et / ou inter-changées pour fournir d'autres réalisations.

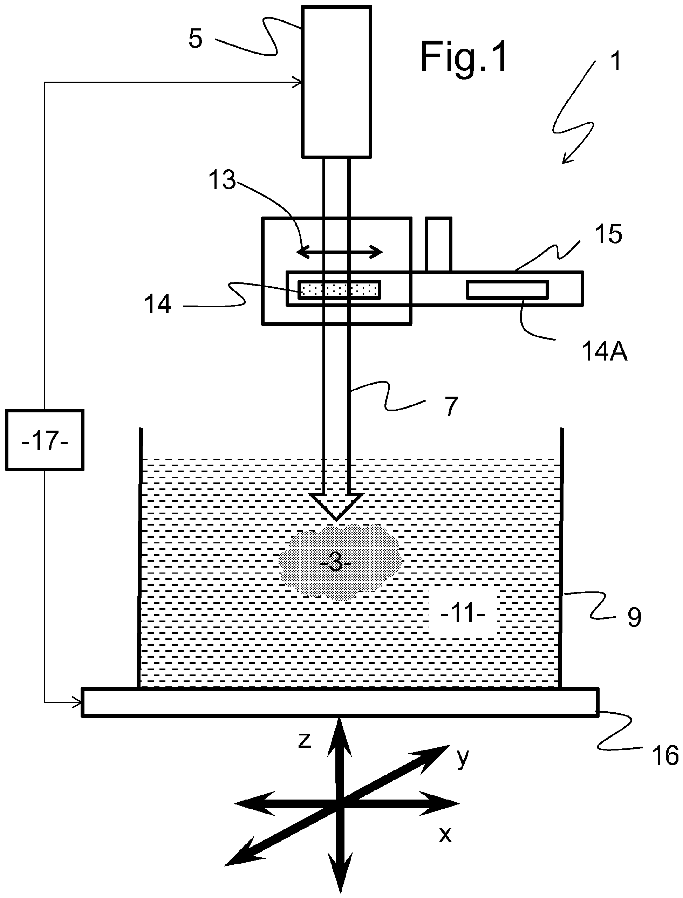

Sur la figure 1 est représenté un système 1 de réalisation d'un objet tridimensionnel 3 par photo-polymérisation multi-photonique.

Ce système 1 comprend un laser 5 émettant un faisceau laser 7 et une cuve 9, formant réacteur de polymérisation, destinée à recevoir une composition 11 adaptée à la photo-polymérisation multi-photonique, notamment à deux photons.

Le laser 5 peut par exemple être un laser impulsionnel et notamment femto/picoseconde émettant par exemple à une longueur d'onde de 1030 nm et couplé, le cas échant, avec des cristaux optiques non linéaires permettant de doubler ou tripler, par un effet non linéaire, la fréquence du faisceau laser afin d'obtenir une longueur d'onde de 515 nm et /ou de 343 nm.

Le choix de la source lumineuse peut dépendre de l'absorption de la composition, pouvant contenir des additifs colorés par exemple. Ainsi, d'autres types de sources lumineuses impulsionnelles peuvent être utilisés.

Le choix de la longueur d'onde de photo-polymérisation multi-photonique, notamment à 2 photons est déterminé par le choix de l'amorceur photochimique et de sa capacité à amorcer des espèces réactives sous l'effet de l'irradiation laser.

Typiquement le diamètre de sortie du faisceau peut être d'environ 2.5 $\mu$m, la divergence de 0.6 mrad et la polarisation linéaire.

L'énergie par impulsion ayant typiquement une durée de 500 fs est comprise entre 40 $\mu$J et 2 mJ et la fréquence de répétition des pulses peut atteindre 300 kHz, mais peut être plutôt autour de 1 kHz.

Bien entendu, un autre laser peut être utilisé pour autant que la longueur d'onde de son faisceau soit adaptée et que la puissance instantanée du laser permette de réaliser la photo-polymérisation multi-photonique, notamment à deux photons, de la composition 11 qui se trouve dans la cuve 9 de polymérisation.

Sur le chemin optique du faisceau laser 7 est disposée une optique de focalisation 13 qui peut être formée par une ou plusieurs lentilles, notamment un objectif pour focaliser le faisceau optique à l'intérieur de la composition 11 et adapter l'ouverture numérique du faisceau.

De façon facultative, un diffuseur 14 peut être placé sur le chemin optique du faisceau laser 7 pour pouvoir contrôler la profondeur de champ du faisceau laser 7. A cet effet, le système comprend un support rotatif 15 avec un trou traversant 14A pour focaliser le faisceau laser 7 sans modification du faisceau dans la composition 11 et des logements dans lequel sont montés respectivement différents diffuseurs permettant d'adapter la profondeur de champ. On peut ainsi, comme cela a été introduit, faire varier la taille des voxels. Le support rotatif 15 avec son ou ses diffuseurs 14 et le trou traversant 14A permet d'ajuster les dimensions des voxels et d'obtenir une résolution variable dans le processus de fabrication en ajustant l'optique de focalisation et la puissance instantanée du faisceau laser 7.

La cuve 9 de polymérisation est, par exemple, placée sur une table 16 déplaçable en x, y et z (voir repères sur la figure 1) pour permettre la polymérisation de la composition 11. Dans ce mode de réalisation particulier, on comprend donc que le point focal ne se déplace pas, mais c'est la cuve 9 qui est déplacée pour positionner le point focal du laser aux endroits à photo-polymériser. Pour ce faire, la table 16 est motorisée pour permettre son déplacement et reliée, comme le laser à une unité 17 de contrôle qui commande à la fois le fonctionnement du laser 5 et le positionnement de la table 16.

Selon une variante non représentée, on place des miroirs mobiles sur le chemin optique du faisceau laser 7 pour diriger le faisceau aux endroits qui devront être photo-polymérisés et un système de focalisation laser et d'adaptation de son ouverture numérique, permettant de déplacer le point focal sur l'axe de propagation. Dans ce cas, les miroirs mobiles sont reliés à une unité de contrôle pour diriger le faisceau laser 7.

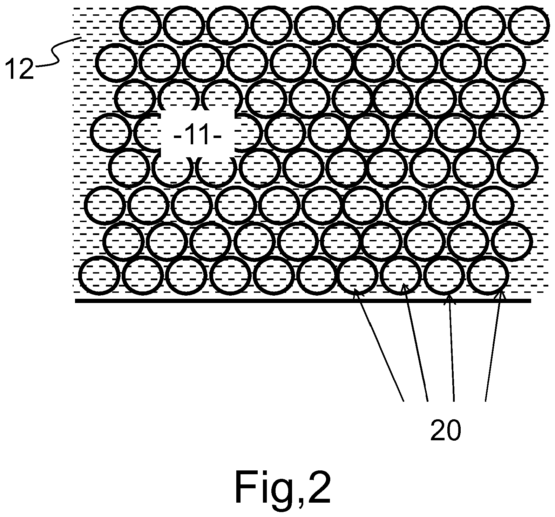

On a représenté de façon simplifiée et schématique sur la figure 2 la composition 11 pour la réalisation d'un objet tridimensionnel 3 par un processus de photo-polymérisation multi-photonique.

Cette composition 11 comprenant au moins un amorceur photochimique, au moins un monomère 12 et au moins une charge 20.

Ces monomères 12 sont transparents à la longueur d'onde prédéterminée de la source pulsée qui sert à la photo-polymérisation. Ces monomères présentent un indice de réfraction $n_{monomères}$ à la longueur d'onde prédéterminée de photo-polymérisation. Par un matériau ou milieu transparent, on entend que le faisceau laser peut passer, au moins en partie (c'est-à-dire qu'il peut être faiblement absorbant), au travers de ce milieu par opposition à un matériau ou un milieu opaque.

Par charge 20, on entend une matière ou un matériau au sens large qui est ajoutée à la composition 11, mais qui ne participe pas à la réaction de polymérisation. La charge 20 peut être considérée inerte par rapport à la polymérisation. Les charges 20 sont transparentes ou très faiblement absorbantes à la longueur d'onde prédéterminée de la source pulsée qui sert à la photo-polymérisation. Ces charges 20 ont un indice de réfraction $n_{charges}$ à la longueur d'onde prédéterminée de photo-polymérisation.

La différence entre l'indice de réfraction $n_{monomères}$ et l'indice de réfraction $n_{charges}$ des charges 20 est inférieure à 0.05 ($|n_{monomères}-n_{charges}|<0.05$), notamment inférieure 0.025 ($|n_{monomères}-n_{charges}|<0.025$) et plus particulièrement inférieure à 0.01 ($|n_{monomères}-n_{charges}|<0.01$), voire l'indice de réfraction des monomères 12 et l'indice de réfraction des charges 20 sont égaux ($|n_{monomères}-n_{charges}| = 0$).

En choisissant une différence d'indices de réfraction faible, voire nulle, cela permet de réduire, voire de supprimer tout phénomène de dispersion du faisceau laser 7 dans la composition 11, notamment aux interfaces entre les monomères et les charges 20 à la longueur d'onde émise par le laser.

L'indice de réfraction $n_{composition}$ de la composition 11 est le résultat de tous ses composants $C_i$ (monomères et charges 20) selon leurs proportions dans la composition.

Ainsi, si $V_R$ est la masse volumique de la composition 11 et $V_{Ri}$ la masse volumique de chacun des composants $C_i$, et $\alpha_i$ est un nombre rationnel compris entre 0 et 1, on a

$$V_R = \sum_{i=1}^{m} \alpha_i V_{Ri}$$

$$\sum_{i=1}^{m} \alpha_i = 1$$

$$n_{composition} = \sum_{i=1}^{m} \alpha_i n_{1i}$$

- $n_{1i}$ étant l'indice de réfraction du composant $C_i$.
- i,j,m étant des nombres entiers, m correspondant au nombre de composants $C_i$ constituant la composition 11.

Dans ce cas, on comprend que par l'ajustement des proportions des composants $C_i$, on peut également ajuster l'indice de réfraction $n_{composition}$ de la composition 11 (et aussi ajuster l'indice de réfraction du ou des monomères d'un côté par rapport à l'indice de réfraction de la charge de l'autre côté) si au moins un indice de réfraction $n_{1i}$ du composant $C_i$, est par exemple inférieur au deuxième indice de réfraction $n_2$ et si au moins un indice de réfraction $n_{1j}$ du composant $C_j$ (i≠j) est par exemple supérieur au deuxième indice de réfraction $n_2$.

La viscosité de la composition 11 peut être ajustée par le choix du pourcentage volumétrique de la charge 20 ; à une valeur d'au moins 0,05 Pa.s et de préférence comprise entre 0,30 à 5,00 Pa.s (Pascal.seconde), afin d'obtenir une composition stable ou figée, c'est-à-dire dans lequel l'objet en cours de fabrication mais aussi la charge 20 ne se déplace pas.

La charge 20 étant par exemple formée de particules transparentes insolubles ou de composants solubles, par exemple des macromolécules solubles comme des polymères acryliques linéaires dissous dans une résine acrylique, dans la composition 11.

La « solubilité » est la capacité d'une substance, appelée soluté, à se dissoudre dans une autre substance, appelée solvant, pour former un mélange homogène appelé solution. Il s'agit donc simplement d'une faculté de deux matières l'une par rapport à l'autre (être soluble ou insoluble l'un par rapport à l'autre).

Lorsque la charge 20 comprend des particules transparentes insolubles, le pourcentage volumétrique est, de préférence, compris entre 10 et 70 % en volume, notamment entre 30% et 60% et plus particulièrement entre 40% et 50%.

Lorsque les charges 20 sont des particules transparentes, elles sont préférentiellement de forme sphérique et possèdent par exemple un diamètre médian compris entre 10$\mu$m et 1500$\mu$m, notamment entre 700um et 1200$\mu$m et plus spécifiquement de 1000$\mu$m. La taille minimale pouvant être choisie selon la limite de diffraction, soit environ 10 fois la longueur d'onde incidente issue du laser.

Les particules transparentes sont, par exemple, réalisées en silice fondue ou en verre, notamment du verre borosilicate ou du verre sodo-calcique. Les particules transparentes peuvent également être des particules organiques, telles que des particules acryliques ou epoxy.

Selon un mode de réalisation préféré de l'invention, les particules transparentes sont mono-disperses, c'est-à-dire toutes de même taille.

Selon un autre mode de réalisation particulier de l'invention, les particules transparentes sont de tailles variables. L'utilisation d'une charge 20 sous forme de particules sphériques transparentes mono-disperses a également pour intérêt de permettre de définir dans certaines configurations la taille des voxels.

En effet, lorsque que le diamètre des particules sphériques 20 est supérieur au volume focal du faisceau laser 7, la taille du voxel n'est plus déterminée par le volume focal du faisceau laser 7 mais par le diamètre des particules transparentes 20. En particulier, la forme des voxels peut ainsi être parfaitement sphérique, bien que le volume focal du faisceau laser 7 ne le soit pas, le faisceau laser 7 servant uniquement à agglomérer au point focal les particules sphériques qui définissent alors la taille les voxels.

Selon un autre mode de l'invention, la composition 11 est une composition solide, par exemple une composition comprenant comme monomères des oligomères de poids moléculaire élevé permettant d'obtenir une composition solide ou quasi-solide à la température ambiante, de sorte que l'on puisse réaliser une photo-polymérisation d'un objet sans avoir à réaliser des appendices de support ou de maintien. Après photo-transformation, la composition 11 peut être chauffée au-delà de la température de fusion de la résine pour séparer l'objet de la résine qui lui a donné naissance. Ceci a pour avantage de diminuer de manière significative le temps de réalisation d'un objet tridimensionnel 3 ainsi que de réaliser des pièces fortement complexes qu'il serait difficile, voire impossible à fabriquer par d'autres méthodes nécessitant la mise en place d'appendices de support.

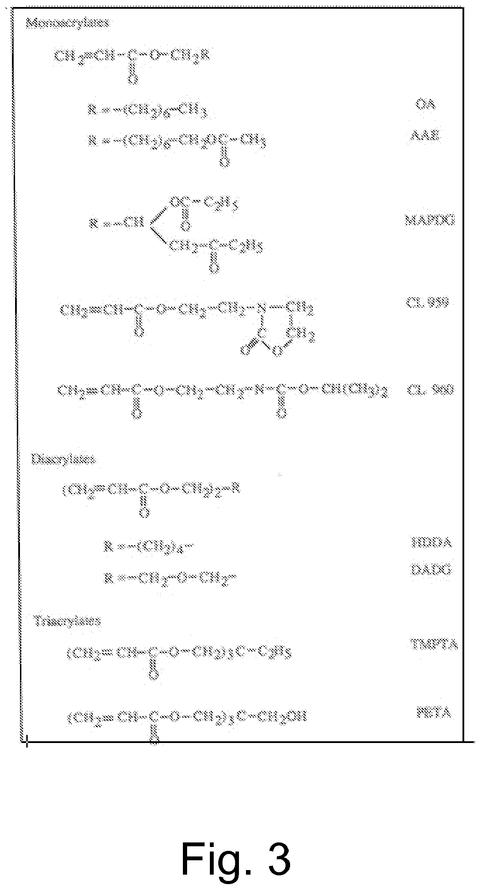

Dans le cas d'une composition liquide, les monomères présents dans la composition 11 sont des monomères couramment utilisés en impression 3D par photo-polymérisation mono- ou multi-photonique. Ces monomères sont par exemple des monomères acryliques, plus spécifiquement acrylates. Une liste non exhaustive de monomères pouvant être utilisés dans la composition 11 de l'invention est décrite dans la figure 3.

On note que la viscosité de la composition visqueuse (supérieure ou égale à 0,05Pa.s = 0,5 poiseuilles a pour effet que la charge, en particulier sous forme de billes, est quasiment figée dans la composition, c'est-à-dire leur déplacement est faible ou quasi nulle lors d'un temps correspondant à une durée de réalisation d'un objet tridimensionnel.

De façon préférentielle, les monomères sont choisis, seuls ou en combinaison, parmi les monomères suivants : poly-(éthylène glycol)-diacrylate, triéthylène glycol-diméthacrylate, pentaerythritol-tetracrylate, 1,6-hexanediol-diacrylate.

Les photo-initiateurs ou photo-amorceurs radicalaires contenus dans la composition 11 doivent permettre d'amorcer la polymérisation à la longueur d'onde prédéterminée de photo-polymérisation. Il existe un grand nombre de photo-amorceurs adaptés selon les conditions opératoires et dont le choix peut être facilement déterminé par l'homme de métier.

Les photo-amorceurs ci-après sont indiqués à titre d'exemple non limitatif de l'invention. Il s'agit typiquement de cétones aromatiques, par exemple la 2,2-dimethoxy-1,2-phenyl acétophénone (DMPA), commercialisée sous le nom Irgacure 651 (marque déposée), de l'éosine Y pour des photo-polymérisations dans le domaine du visible, ou des amorceurs thermiques comme le peroxyde de benzoyle pour des photo-polymérisations dans le domaine IR ou encore d'autres colorants xanthéniques.

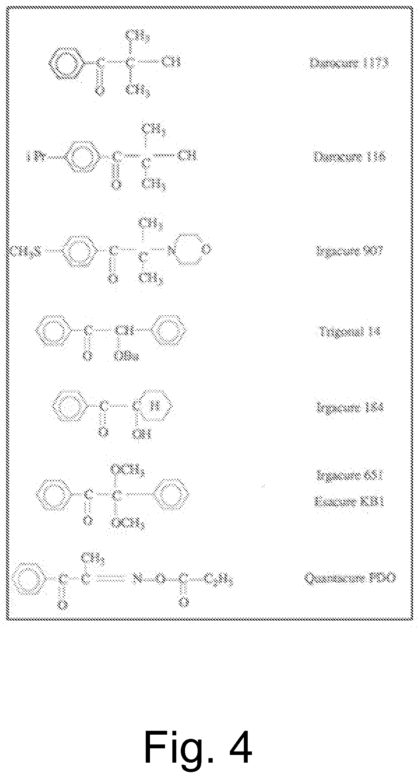

Des photo-amorceurs particulièrement adaptés au procédé selon l'invention sont représentés dans la figure 4 et sont commercialisés sous les noms commerciaux (marques déposées) Darocure 1173 et 116, le Quantacure PDO, les Irgacure 184, 651 et 907 et le Trigonal 14.

De façon préférentielle, l'amorceur photochimique radicalaire est la DMPA commercialisée sous le nom d'Irgacure 651 (marque déposée).

Selon un autre mode de réalisation, le procédé de l'invention utilise un mécanisme de photo-polymérisation ionique, par exemple cationique auquel cas, les monomères présents dans la composition 11 sont, par exemple, des monomères epoxy et le photo-amorceur un sel d'onium (par exemple le rhodorsil 2074 (marque déposée)) La référence suivante : Vairon, J.-P.; Spassky, N. Industrial Cationic Polymerization: An Overview. In Cationic Polymerizations; Matyjaszewski, K., Ed.; Marcel Dekker: New York, NY, USA, 1996; pp. 683-750 indique une liste de différents amorceurs photochimiques utilisables dans le procédé faisant l'objet de l'invention.

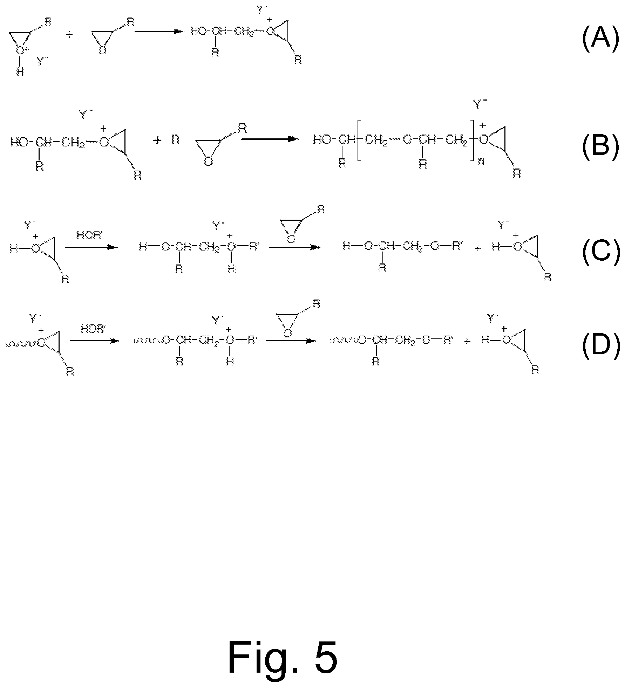

La figure 5 illustre un mécanisme classique de polymérisation ionique avec les étapes suivantes : amorçage (A), propagations (B) et (C), transfert (D).

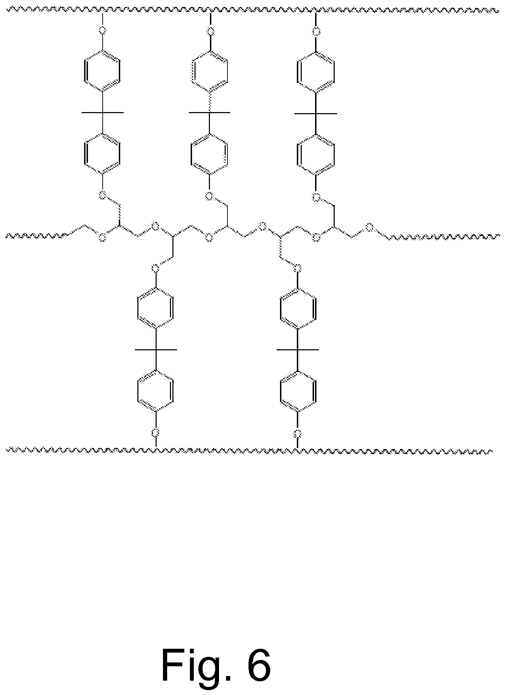

Avec des monomères multifonctionnels, des systèmes réticulés, insolubles dans la résine initiale, peuvent être formés comme l'indique le schéma de la figure 6.

En dehors des composés de la famille des époxys, il est possible d'utiliser un grand nombre de monomères décrits de manière synthétique dans la référence suivante : "Polymers 2013, 5, 361-403; doi:10.3390/polym5020361 Ring-Opening Polymerization-An Introductory Review" par Oskar Nuyken et Stephen D. Pask.

Comme indiqué précédemment, une optique de focalisation 13 et un diffuseur 14 permettant de contrôler la profondeur de champ du faisceau laser sont disposés sur le chemin optique du faisceau laser.

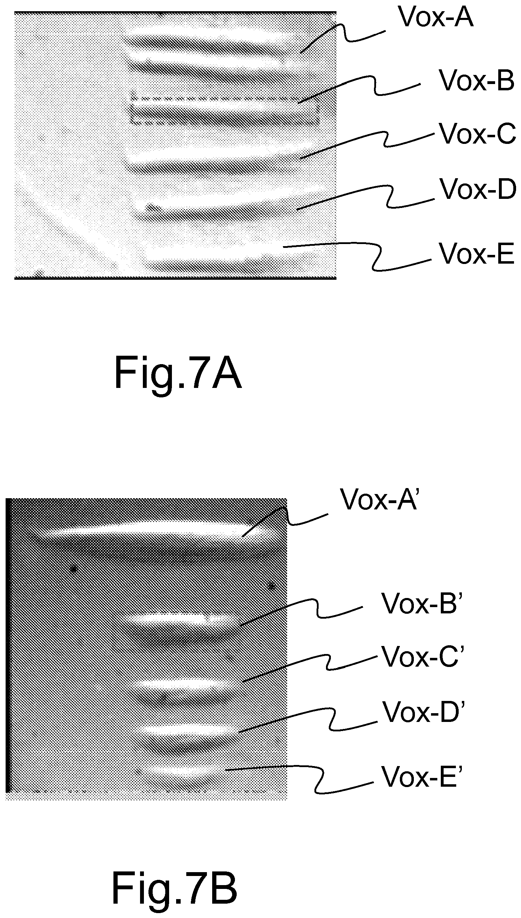

La figure 7A montre plusieurs voxels photo-polymérisés vox-A, vox-B, vox-C et vox-D, vox-E sans diffuseur avec différentes puissances.

La figure 7B montre plusieurs voxels photo-polymérisés vox-A', vox-B', vox-C' et vox-D', vox-E', avec un diffuseur 14 sur le chemin optique du faisceau laser 7, et à des puissances de faisceau différents.

L'utilisation d'un diffuseur adapté entre 1° et 20° (un diffuseur 1° signifie une ouverture du faisceau laser en sortie du diffuseur de 1°) permet de faire varier la taille des voxels photo-polymérisés. Cependant, de manière évidente, la puissance de la source doit être adaptée pour que la densité de puissance soit identique, ou la plus proche possible de celle défini pour les voxels de plus petite taille (sensiblement variant entre le carré et le cube de la taille du voxel).

Du fait d'une viscosité élevée de la composition 11 (par exemple > 1.00 Pa.s), le procédé selon l'invention permet de concevoir la réalisation d'objets tridimensionnels de taille au moins centimétrique sans recourir à des d'appendices de support ou de maintien pour des objets.

Le procédé selon l'invention permet également de réduire le temps nécessaire la réalisation de l'objet tridimensionnel 3 par photo-polymérisation multi-photonique, notamment à deux photons.

En effet, il est possible de distinguer dans l'objet tridimensionnel 3 une surface externe et un volume interne. L'optimisation consiste alors à polymériser des endroits localisés dans le volume interne (partie massive) avec une faible résolution, déterminée en fonction de l'objet à imprimer, et à polymériser les zones formant la surface externe de l'objet tridimensionnel 3 avec une résolution élevée pour obtenir un état de surface présentant de bonne qualité pour la (les) surface(s) externe(s) de l'objet tridimensionnel 3.

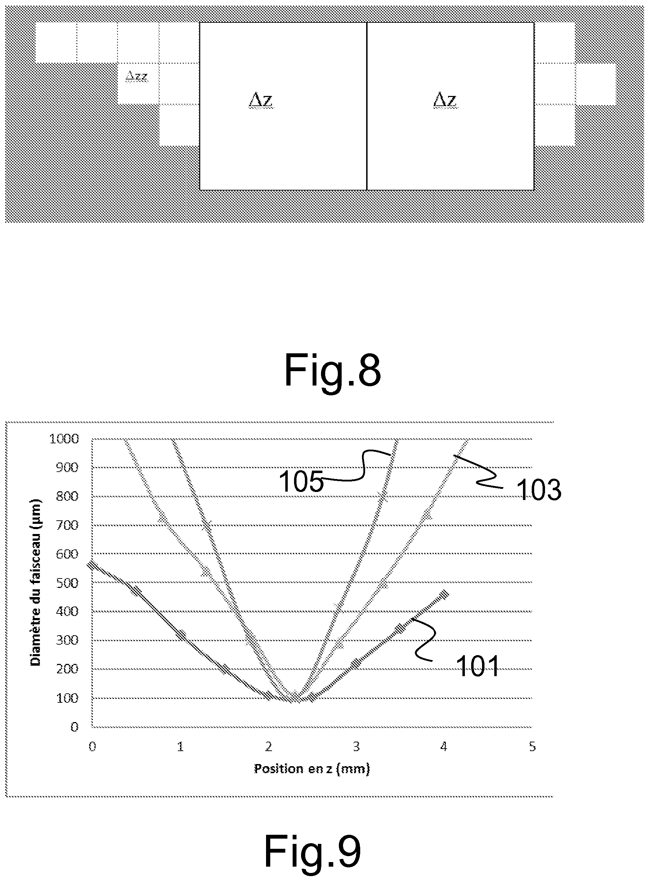

Ceci est représenté de façon schématique sur la figure 8. Par simplification de présentation, on suppose que les voxels sont des cubes et que l'on dispose, par exemple, au moins d'une première résolution permettant de réaliser des voxels de taille $\Delta z$ et une seconde résolution, plus fine, permettant de réaliser des voxels $\Delta zz$ de taille plus petite, par exemple $10*\Delta zz = \Delta z$.

On comprend aisément que si les voxels à l'intérieur de l'objet tridimensionnel sont réalisés avec la résolution $\Delta z$ et les voxels formant la surface externe de l'objet tridimensionnel avec la résolution $\Delta zz$, on peut diminuer le temps de fabrication de l'objet tridimensionnel de manière significative.

Selon un mode particulier de l'invention, la fabrication de l'objet tridimensionnel 3 peut être réalisée de façon successive, le volume interne étant polymérisé à partir d'une composition 11 comprenant des charges 20 sous forme de particules transparentes de dimensions importantes permettant d'obtenir une taille de voxel élevée par rapport à l'objet 3 à fabriquer. La partie interne de l'objet est ensuite retirée de la cuve 9 comprenant la composition 11. La partie interne est ensuite plongée dans une cuve 9 comprenant une seconde composition 11 comprenant des particules transparentes de dimensions plus fines que la composition 11 précédente voir ne contenant pas de particules pour la polymérisation de la surface externe de l'objet 3. Ces compositions 11 successives permettant de réduire la taille des voxels en fonction de la finition de l'objet tridimensionnel 3 à former. Le procédé permet ainsi de polymériser en des endroits localisés dans le volume interne avec une résolution plus faible que les endroits formant la surface externe de l'objet tridimensionnel.

Bien entendu, on peut généraliser ce procédé et prévoir de réaliser différentes portions de l'objet tridimensionnel 3 successivement par polymérisation dans différentes cuves 9 contenant chacune une composition 11 spécifique permettant d'obtenir une taille de voxel prédéterminée.

Le procédé selon l'invention permet ainsi de réaliser facilement et rapidement des objets tridimensionnels 3 dont la forme peut être plus complexe que celle accessible aux méthodes classiques de stéréo-lithographie. On peut ainsi envisager la fabrication d'objets complexes ayant des dimensions centimétriques, voir une dizaine de centimètres de taille avec un temps de fabrication raisonnable et sans recours à des éléments de maintien.

Ce procédé présente donc un avantage déterminant relativement à la SLA à un photon puisque l'épaisseur de couche ne peut pas, en général, être modifiée facilement lors de la polymérisation d'une couche de résine : s'il est possible de modifier la taille du spot lumineux, seuls deux paramètres d'espace (voxel) peuvent être modifiés, alors que selon le procédé faisant l'objet de l'invention, permet d'ajuster la taille des voxels en fonction de trois paramètres, le diamètre du voxel, et la profondeur et la puissance de la source lumineuse 5 pour réaliser un objet selon une consigne tenant compte de l'état de surface.

Selon un mode particulier de l'invention, le procédé de l'invention est un procédé de bio-impression auquel cas, la composition 11 comprend des monomères, des charges, des matériels biologiques et un hydrogel.

A titre d'exemple non limitatif de l'invention, les monomères 12 utilisés sont choisis parmi l'acide L-lactique, de l'acide glycolique, des capro-lactones, considérés seuls ou en mélange. Le photo-amorceur peut-être choisi parmi les cétones aromatiques, telles que la benzophénone ou l'irgacure.

Les charges 20 comprennent des cellules vivantes. Selon un mode de réalisation particulièrement favorable, les charges 20 sont composées de « billes » comprenant lesdites cellules, ces billes étant par exemple un mélange de collagène et de cellules vivantes.

Un hydrogel est nécessaire afin de préserver la viabilité des cellules lors de l'impression. A titre d'exemple non limitatif de l'invention, l'hydrogel peut être choisi parmi le collagène, la gélatine, la fibrine, l'alginate, la chitine, le chitosane, l'acide hyaluronique, le (poly-(2-hydroxyethyl méthacrylate) (PHEMA), l'alcool polyvinylique (PVA) et le poly-éthylèneglycol (PEG) considérés seuls ou en mélange.

Le retrait d'un objet imprimé de la cuve en présence de charge 20 sous forme de billes ou particules peut se faire de façon classique par retrait à la pince, ou bien avec un tamis, et les particules surnuméraires qui forment avec la résine monomère non-polymérisée un film sur l'objet retiré, peuvent alors être éliminées par essuyage ou au moyen d'un bain ou rinçage avec un solvant qui dissout la résine non-polymérisée, étape qui est généralement déjà effectué à la fin des impressions en résine dans la masse. Dans certains cas, la fluidification de la résine non polymérisée peut se faire en ajoutant du monomère liquide ce qui autorise un recyclage des matières non transformées ou à l'aide d'un solvant classique du monomère.

En particulier, même si les billes ou particules de la charge 20 devaient être en contact mutuel (densité de charge maximale) voire en empilement compact, la résine s'insère dans les creux restants et, en polymérisant, lie les particules autour des points où le laser aura été focalisé. Les particules en périphérie, non ou insuffisamment liées par polymérisation sont alors enlevées lors d'un rinçage au solvant.

EXEMPLES

Exemple 1 (compositions)

Monomères

Les monomères et compositions suivantes sont particulièrement adaptés à l'invention :

| Référence | Fabricant | Composition | Indice de réfraction mesuré | viscosité |
|-----------|-----------|-------------|------------------------------|-----------|
| PEGDA 575 | Servilab (SIGMA) | Poly(ethylène glycol)diacry late | 1.468 | 0.05 Pa.s |
| TEGDA | Servilab (SIGMA) | Tri(ethylène glycol)diacry late 95% | 1.4585 | 0.02 Pa.s |
| PETA | Servilab (SIGMA) | Pentaerythrit ol tetraacrylate | 1.484 | 0.60 Pa.s |
| HDDA | Servilab (SIGMA) | 1,6-hexanediol diacrylate | 1.456 | 0.02 Pa.s |
| Norland 65 | Thorlab (Norland) | | 1.499 | 1.20 Pa.s |
| Norland 81 | Thorlab (Norland) | | 1.523 | 0.30 Pa.s |

Les indices de réfraction ont été mesurés par un réfractomètre d'Abbe (Kern Optics ORT 1RS Réfractomètre) étalonné à l'aide d'une huile de calibration

Charges de particules transparentes

| Référence | Fabriquant | Composition | Diamètre | Indice de réfraction |
|-----------|-----------|-------------|----------|----------------------|
| Borosilicate solid-glass beads | Sigma-Aldrich | Borosilicate | 1 mm | 1.47 |
| Glass-beads, acid-washed | Sigma-Aldrich | Verre sodocalcique | 700-1200 μm | 1.52 |

Les valeurs des indices de réfraction ont été estimées à partir de données bibliographiques telles que (http://refractiveindex.info/), SCHOTT optical glass data (http://refractiveindex.info/), sheets 2015-07-22, ou M. Rubin. Optical properties of soda lime silica glasses, Solar Energy Materials 12, 275-288 (1985)

Exemples de compositions selon l'invention :

Composition 1

| | Composé | Indice de réfraction |
|---|---------|----------------------|
| Monomère | PEGDA (575) | 1.47 |

(suite)

|  | Composé | Indice de réfraction |
|---|---|---|
| Photo-amorceur | IRAGACURE 651 | Influence négligeable |
| Charge (50 % du volume de la composition totale) | Borosilicate solid-glass beads (diamètre 1 mm) | 1.47 |

Composition 2

|  | Composé | Indice de réfraction |
|---|---|---|
| Résine | Norland 81 | 1.523 |
| Charge (50 % du volume de la composition totale) | Glass-beads, acid-washed (700-1200 $\mu$m) | 1.52 |

Les résines Norland incorporent un photo-initiateur et ont été utilisées sans ajout d'initiateur/amorceur complémentaire.

Composition 3

La valeur de l'indice de réfraction étant définie par la relation :

$$n = n_1.\alpha + n_2 \ (1 - \alpha)$$

avec $n_1$ l'indice de réfraction du composé 1, $n_2$ l'indice de réfraction du composé 2 et $\alpha$ la part massique de composé 1 dans la composition 11.

La composition suivante est un exemple selon l'invention

|  | Composé | Indice de réfraction |
|---|---|---|
| Monomère (47.5 % du volume de la composition totale) | PEGDA | 1.47 |
| Résine (2.5 % du volume de la composition totale) | Norland 65 | 1.499 |
| Photo-initiateur | IRGACURE 651 | Influence négligeable |
| Charge (50 % du volume de la composition totale) | Borosilicate solid-glass beads (diamètre 1 mm) | 1.52 |

Cette composition a été polymérisée par polymérisation à 2 photons en utilisant un laser Yb : KGW doublé en fréquence à 515nm avec des durées d'impulsion de 500fs pour obtenir un objet, sous forme de double barre, de 9mm.

Les compositions 1-3 présentent une viscosité satisfaisante pour éviter les déplacements de l'objet à imprimer et présente une faible variation de l'indice de réfraction de ces différent composants. La composition est également transparente à la longueur d'onde prédéterminée de photo-polymérisation.

Exemple 2 (voxels variables)

Une expérience a été réalisée afin de déterminer les effets de diffuseurs placés en entrée de l'objectif et permettant de présenter une large gamme de fréquences spatiales. En effet, si le faisceau initial se caractérise comme une onde plane se propageant dans une certaine direction, le diffuseur sépare cette onde en de multiples ondes se propageant de façon aléatoire dans un angle caractéristique du diffuseur (lié à la rugosité ou « fréquence spatiale »)

Le dispositif comprend un laser He/Ne de longueur d'onde 543 nm, un objectif à longue distance de travail et un jeu de différents diffuseurs montés sur une roue à filtre.

La mesure de la caustique du faisceau laser est reportée à la figure 9. Ces mesures permettent de déterminer l'influence des diffuseurs sur le diamètre du faisceau laser.

Sur cette figure 9 sont représentés trois courbes 101, 103 et 105. La courbe 101 montre le diamètre du faisceau en $\mu$m en fonction de la position en z en mm sans diffuseur, la courbe 103 avec un diffuseur de 1° et la courbe 105 avec un diffuseur de 10°.

On observe que cette méthode rend possible le contrôle de la profondeur de champ du faisceau gaussien sans réduire le diamètre du faisceau au point focal et ainsi de contrôler les dimensions du voxel.

Dans le cas présent, le diamètre du faisceau peut atteindre 100 $\mu$m de diamètre et une profondeur de champ définie par une augmentation de diamètre de $2^{0.5}$, d'environ 300$\mu$m soit un rapport diamètre : profondeur de l'ordre de 0.3 (figures 3).

## Revendications

1. Procédé de réalisation d'un objet tridimensionnel comprenant les opérations suivantes:

   a. introduire une composition (11) dans une cuve (9) de polymérisation,
   b. polymériser par photo-polymérisation multi-photonique, à des endroits prédéterminés, la composition (11) pour réaliser l'objet tridimensionnel (3), la composition (11) comprenant au moins un monomère (12), au moins une charge (20) et au moins un photo-amorceur,

   • **caractérisée en ce que** : la différence entre les indices de réfraction du monomère (12) et de la charge (20) présent est inférieure à 0.05 ;
   • la viscosité de la composition (11) est supérieure ou égale à 0.05 Pa.s ;
   • la composition (11) est transparente à la longueur d'onde de photo-polymérisation.

2. Procédé selon la revendication 1 pour lequel la composition (11) a une valeur de viscosité supérieure ou égale à 0.30 Pa.s.

3. Procédé selon l'une des revendications précédentes pour lequel la charge (20) comprend des particules transparentes.

4. Procédé selon la revendication 3 pour lequel la composition (11) comprend de 10 à 70 % en volume de particules transparentes.

5. Procédé selon l'une des revendications 3 ou 4 pour lequel les particules transparentes sont de forme sphérique.

6. Procédé selon l'une des revendications 3 à 5 pour lequel les particules transparentes sont réalisées en silice, en verre, notamment du verre borosilicate ou du verre sodo-calcique.

7. Procédé selon l'une des revendications 3 à 5 pour lequel les particules transparentes sont réalisées en matériau organique, notamment avec des polymères insolubles dans la résine.

8. Procédé selon l'une des revendications précédentes pour lequel la charge (20) comprend au moins un composant soluble dans la composition (11).

9. Procédé selon l'une des revendications précédentes pour lequel la composition (11) comprend des monomères choisis parmi l'acide L-lactique, de l'acide glycolique, des capro-lactones, considérés seuls ou en mélange, des charges (20) comprenant des cellules vivantes, un hydrogel choisi parmi le collagène, la gélatine, la fibrine, l'alginate, la chitine, le chitosane, l'acide hyaluronique, le (poly-(2-hydroxyethyl méthacrylate) (PHEMA), l'alcool polyvinylique (PVA) et le poly-éthylèneglycol (PEG) considérés seuls ou en mélange.

10. Procédé selon l'une des revendications 1 à 8 pour lequel le monomère est un monomère acrylique.

11. Procédé selon la revendication 10 pour lequel le monomère acrylique est choisi parmi le groupe suivant : du poly-(éthylène glycol)-diacrylate, du tri(ethylène glycol)-dimethacrylate, du pentaerythritol-tetracrylate, du 1,6-hexanediol-diacrylate, ou en combinaison.

12. Procédé selon l'une des revendications 10 ou 11 **caractérisé en ce que** le ou les photo-amorceurs sont choisis dans le groupe suivant : cétones aromatiques, des dérivés aromatiques, de l'éosine Y et autres colorants xanthéniques.

13. Procédé selon l'une des revendications 1 à 8 et 10 à 12 pour lequel la composition (11) comprend au moins un monomère époxy.

14. Procédé selon la revendication 13 pour lequel le photo-amorceur est un sel d'onium.

15. Procédé selon l'une des revendications précédentes dans lequel on réalise la photo-polymérisation multi-photonique à l'aide d'un faisceau laser, **caractérisé en ce que** l'on adapte la résolution spatiale de polymérisation en plaçant un diffuseur optique (14), notamment entre 1° et 20°, dans le faisceau laser.

16. Procédé selon l'une des revendications 3 à 15, dans lequel l'objet tridimensionnel (3) comprend une surface externe et un volume interne **caractérisé en ce que** l'on polymérise des endroits localisés dans le volume interne avec une résolution plus faible que les endroits formant la (les) surface(s) externe(s) de l'objet tridimensionnel (3).

17. Procédé selon la revendication 16, **caractérisé en ce que** différentes portions de l'objet tridimensionnel (3) sont successivement polymérisés dans différentes cuves (9) contenant chacune une composition (11) spécifique permettant d'obtenir une taille de voxel, voire des fonctionnalités prédéterminées.

18. Procédé selon l'une des revendication 3 à 17, **caractérisé en ce que** le volume interne est polymérisé dans une première cuve (9) contenant une première composition (11) comprenant des premières charges (20) sous forme de particules transparentes permettant d'obtenir une première taille de voxel et **en ce que** la partie externe de l'objet (3) est polymérisé dans une deuxième cuve (9) contenant une seconde composition (11) comprenant des deuxième charges (20) sous forme de particules transparentes ou aucune charge permettant d'obtenir une seconde taille de voxel, inférieure à la première taille de voxel.

19. Dispositif de réalisation d'un objet tridimensionnel par photo-polymérisation multi-photonique, notamment à deux photons comprenant :

   - un laser (5) émettant un faisceau laser (7),
   - une cuve (9) de polymérisation contenant une composition (11) comprenant :

     ◦ au moins un monomère (12),
     ◦ au moins une charge (20) et
     ◦ au moins un photo-amorceur,

   dans laquelle :

     ◦ la différence entre les indices de réfraction du monomère (12) et de la charge (20) présente est inférieure à 0.05, la viscosité de la composition (11) est supérieure ou égale à 0.05 Pa.s,
     ◦ la composition (11) est transparente à la longueur d'onde de photo-polymérisation,

   - un dispositif (13) de focalisation du faisceau laser et d'adaptation de son ouverture numérique (7),
   - une unité (16) de déplacement pour permettre la focalisation du faisceau laser (7) à l'intérieur de la cuve (9) de polymérisation en vue de polymériser la composition (11) aux endroits prédéterminés pour réaliser l'objet tridimensionnel (3),
   - un adaptateur de résolution de polymérisation comprenant au moins un diffuseur (14) monté mobile sur un support (15) pour être placé sur le chemin optique ou en dehors du faisceau laser (7) afin d'adapter la résolution de polymérisation.

**Patentansprüche**

1.  Verfahren zur Herstellung eines dreidimensionalen Gegenstands, wobei es die folgenden Vorgänge umfasst:

    a. Einleiten einer Zusammensetzung (11) in einen Polymerisationsbehälter (9),
    b. Polymerisieren der Zusammensetzung (11) an vorbestimmten Stellen durch multiphotonische Photopolymerisation, um den dreidimensionalen Gegenstand (3) herzustellen, wobei die Zusammensetzung (11) mindestens ein Monomer (12), mindestens einen Füllstoff (20) und mindestens einen Photoinitiator umfasst,

    • **dadurch gekennzeichnet, dass**: der Unterschied zwischen den Brechungsindizes des Monomers (12) und des Füllstoffs (20) vorliegend geringer als 0,05 ist;
    • die Viskosität der Zusammensetzung (11) mindestens 0,05 Pa.s beträgt;
    • die Zusammensetzung (11) bei der Wellenlänge der Photopolymerisation durchsichtig ist.

2.  Verfahren nach Anspruch 1, wobei die Zusammensetzung (11) einen Viskositätswert von mindestens 0,30 Pa.s hat.

3.  Verfahren nach einem der vorhergehenden Ansprüche, wobei der Füllstoff (20) durchsichtige Partikel umfasst.

4.  Verfahren nach Anspruch 3, wobei die Zusammensetzung (11) 10 bis 70 Volumen-% an durchsichtigen Partikeln umfasst.

5.  Verfahren nach einem der Ansprüche 3 oder 4, wobei die durchsichtigen Partikel von kugelförmiger Gestalt sind.

6.  Verfahren nach einem der Ansprüche 3 bis 5, wobei die durchsichtigen Partikel aus Siliciumdioxid, aus Glas, insbesondere aus Borosilikatglas oder aus Kalk-Natron-Glas, hergestellt sind.

7.  Verfahren nach einem der Ansprüche 3 bis 5, wobei die durchsichtigen Partikel aus einem organischen Material hergestellt sind, insbesondere mit Polymeren, die in dem Harz unlöslich sind.

8.  Verfahren nach einem der vorhergehenden Ansprüche, wobei der Füllstoff (20) mindestens einen Bestandteil umfasst, welcher in der Zusammensetzung (11) löslich ist.

9.  Verfahren nach einem der vorhergehenden Ansprüche, wobei die Zusammensetzung (11) Monomere, welche aus L-Milchsäure, Glykolsäure, Caprolactonen, jeweils für sich genommen oder in Mischung, ausgewählt sind, Füllstoffe (20), welche lebende Zellen umfassen, ein Hydrogel umfasst, welches aus Kollagen, Gelatine, Fibrin, Alginat, Chitin, Chitosan, Hyaluronsäure, Poly-(2-hydroxyethylmethacrylat) (PHEMA), Polyvinylalkohol (PVA) und Polyethylenglykol (PEG), jeweils für sich genommen oder in Mischung, ausgewählt sind.

10. Verfahren nach einem der Ansprüche 1 bis 8, wobei es sich bei dem Monomer um ein Acrylsäuremonomer handelt.

11. Verfahren nach Anspruch 10, wobei das Acrylsäuremonomer aus der folgenden Gruppe ausgewählt ist: Poly(ethylenglykol)diacrylat, Tri(ethylenglykol)dimethacrylat, Pentaerythrit-Tetracrylat, 1,6-Hexandioldiacrylat, wobei diese auch in Kombination vorliegen können.

12. Verfahren nach einem der Ansprüche 10 oder 11, **dadurch gekennzeichnet, dass** der oder die Photoinitiatoren aus der folgenden Gruppe ausgewählt sind: aromatischen Ketonen, aromatischen Derivaten, Eosin Y und anderen Xanthenfarbstoffen.

13. Verfahren nach einem der Ansprüche 1 bis 8 und 10 bis 12, wobei die Zusammensetzung (11) mindestens ein Epoxymonomer umfasst.

14. Verfahren nach Anspruch 13, wobei es sich bei dem Photoinitiator um ein Oniumsalz handelt.

15. Verfahren nach einem der vorhergehenden Ansprüche, wobei die multiphotonische Photopolymerisation mit Hilfe eines Laserstrahls durchgeführt wird, **dadurch gekennzeichnet, dass** die räumliche Polymerisationsauflösung angepasst wird, indem ein optischer Diffusor (14), insbesondere zwischen 1° und 20°, in dem Laserstrahl angeordnet wird.

**16.** Verfahren nach einem der Ansprüche 3 bis 15, wobei der dreidimensionale Gegenstand (3) eine außenliegende Fläche und ein Innenvolumen umfasst, **dadurch gekennzeichnet, dass** Stellen, welche sich in dem Innenvolumen befinden, mit einer geringeren Auflösung polymerisiert werden als Stellen, welche die außenliegende(n) Fläche(n) des dreidimensionalen Gegenstands (3) bilden.

**17.** Verfahren nach Anspruch 16, **dadurch gekennzeichnet, dass** die verschiedenen Abschnitte des dreidimensionalen Gegenstands (3) nacheinander in verschiedenen Behältern (9) polymerisiert werden, die jeweils eine spezifische Zusammensetzung (11) enthalten, welche es ermöglicht, eine Voxel-Größe, oder sogar vorbestimmte funktionelle Eigenschaften zu erzielen.

**18.** Verfahren nach einem der Ansprüche 3 bis 17, **dadurch gekennzeichnet, dass** das Innenvolumen in einem ersten Behälter (9) polymerisiert wird, welcher eine erste Zusammensetzung (11) enthält, die erste Füllstoffe (20) in Form von durchsichtigen Partikeln umfasst, wobei sie es ermöglicht, eine erste Voxel-Größe zu erzielen, und dadurch, dass der außenliegende Bereich des Gegenstands (3) in einem zweiten Behälter (9) polymerisiert wird, welcher eine zweite Zusammensetzung (11) enthält, die zweite Füllstoffe (20) in Form von durchsichtigen Partikeln oder keinerlei Füllstoff umfasst, wobei sie es ermöglicht, eine zweite Voxel-Größe zu erzielen, die geringer als die erste Voxel-Größe ist.

**19.** Vorrichtung zur Herstellung eines dreidimensionalen Gegenstands durch multiphotonische Photopolymerisation, insbesondere mit zwei Photonen, wobei sie Folgendes umfasst:

- einen Laser (5), der einen Laserstrahl (7) aussendet,
- einen Polymerisationsbehälter (9), der eine zweite Zusammensetzung (11) enthält, welche Folgendes umfasst:

  ◦ mindestens ein Monomer (12),
  ◦ mindestens einen Füllstoff (20), und
  ◦ mindestens einen Photoinitiator,

  wobei:

  ◦ der Unterschied zwischen den Brechungsindizes des Monomers (12) und des vorliegenden Füllstoffs (20) weniger als 0,05 beträgt, die Viskosität der Zusammensetzung (11) mindestens 0,05 Pa.s beträgt,
  ◦ die Zusammensetzung (11) bei der Wellenlänge der Photopolymerisation durchsichtig ist,

- eine Vorrichtung (13) zur Fokussierung des Laserstrahls und zur Anpassung von dessen numerischer Apertur (7),
- eine Verschiebungseinheit (16), um es zu ermöglichen, den Laserstrahl (7) im Inneren des Polymerisationsbehälters (9) zu fokussieren, sodass die Zusammensetzung (11) an vorbestimmten Stellen polymerisiert wird, um den dreidimensionalen Gegenstand (3) herzustellen,
- einen Polymerisationsauflösungsadapter, der mindestens einen Diffusor (14) umfasst, welcher beweglich an einem Träger (15) angebracht ist, um ihn entlang des optischen Wegs oder außerhalb des Laserstrahls (7) anzuordnen, was dazu dient, die Polymerisationsauflösung anzupassen.

**Claims**

**1.** Process for producing a three-dimensional object comprising the following operations:

  a. introducing a composition (11) into a polymerization vessel (9),
  b. polymerizing the composition (11) by multiphoton photopolymerization, at predetermined locations, in order to produce the three-dimensional object (3), the composition (11) comprising at least one monomer (12), at least one filler (20) and at least one photoinitiator,

  • **characterized in that**: the difference between the refractive indices of the monomer (12) and of the filler (20) present is less than 0.05;
  • the viscosity of the composition (11) is greater than or equal to 0.05 Pa.s;
  • the composition (11) is transparent to the photopolymerization wavelength.

**2.** Process according to Claim 1, wherein the composition (11) has a viscosity value greater than or equal to 0.30 Pa.s.

**3.** Process according to either of the preceding claims, wherein the filler (20) comprises transparent particles.

**4.** Process according to Claim 3, wherein the composition (11) comprises from 10 to 70% by volume of transparent particles.

**5.** Process according to either of Claims 3 or 4, wherein the transparent particles are of spherical shape.

**6.** Process according to one of Claims 3 to 5, wherein the transparent particles are made of silica, of glass, in particular of borosilicate glass or of soda-lime glass.

**7.** Process according to one of Claims 3 to 5, wherein the transparent particles are made of organic material, in particular with polymers that are insoluble in the resin.

**8.** Process according to one of the preceding claims, wherein the filler (20) comprises at least one component that is soluble in the composition (11).

**9.** Process according to one of the preceding claims, wherein the composition (11) comprises monomers selected from L-lactic acid, glycolic acid, caprolactones, considered alone or as a mixture, fillers (20) comprising living cells, a hydrogel selected from collagen, gelatin, fibrin, alginate, chitin, chitosan, hyaluronic acid, poly-(2-hydroxyethyl methacrylate) (PHEMA), polyvinyl alcohol (PVA) and polyethylene glycol (PEG) considered alone or as a mixture.

**10.** Process according to one of Claims 1 to 8, wherein the monomer is an acrylic monomer.

**11.** Process according to Claim 10, wherein the acrylic monomer is selected from the following group: poly(ethylene glycol) diacrylate, tri(ethylene glycol) dimethacrylate, pentaerythritol tetraacrylate, 1,6-hexanediol diacrylate, or in combination.

**12.** Process according to either of Claims 10 or 11, **characterized in that** the photoinitiator(s) is (are) selected from the following group: aromatic ketones, aromatic derivatives, eosin Y and other xanthene dyes.

**13.** Process according to one of Claims 1 to 8 and 10 to 12, wherein the composition (11) comprises at least one epoxy monomer.

**14.** Process according to Claim 13, wherein the photoinitiator is an onium salt.

**15.** Process according to one of the preceding claims, wherein the multiphoton photopolymerization is carried out using a laser beam, **characterized in that** the polymerization spatial resolution is adapted by placing an optical diffuser (14), in particular between 1° and 20°, in the laser beam.

**16.** Process according to one of Claims 3 to 15, wherein the three-dimensional object (3) comprises an outer surface and an inner volume **characterized in that** localized locations in the inner volume are polymerized with a lower resolution than the locations forming the outer surface(s) of the three-dimensional object (3).

**17.** Process according to Claim 16, **characterized in that** various portions of the three-dimensional object (3) are successively polymerized in various vessels (9) each containing a specific composition (11) that makes it possible to obtain a voxel size, or even functionalities that are predetermined.

**18.** Process according to one of Claims 3 to 17, **characterized in that** the inner volume is polymerized in a first vessel (9) containing a first composition (11) comprising first fillers (20) in the form of transparent particles making it possible to obtain a first voxel size and **in that** the outer part of the object (3) is polymerized in a second vessel (9) containing a second composition (11) comprising second fillers (20) in the form of transparent particles or no filler making it possible to obtain a second voxel size, smaller than the first voxel size.

**19.** Device for producing a three-dimensional object by multiphoton, in particular two-photon, photopolymerization, comprising:

- a laser (5) emitting a laser beam (7),
- a polymerization vessel (9) containing a composition (11) comprising:

  • at least one monomer (12),
  • at least one filler (20) and
  • at least one photoinitiator,

wherein:

  • the difference between the refractive indices of the monomer (12) and of the filler (20) present is less than 0.05, the viscosity of the composition (11) is greater than or equal to 0.05 Pa.s,
  • the composition (11) is transparent to the photopolymerization wavelength,

- a device (13) for focusing the laser beam and adapting the numerical aperture (7) thereof,
- a displacement unit (16) for enabling the focusing of the laser beam (7) inside the polymerization vessel (9) with a view to polymerizing the composition (11) at the predetermined locations in order to produce the three-dimensional object (3),
- a polymerization resolution adapter comprising at least one diffuser (14) movably mounted on a support (15) in order to be placed on the optical path or outside of the laser beam (7) in order to adapt the polymerization resolution.

Fig.1

Fig,2

Fig. 3

20

# Fig. 4

(A)

(B)

(C)

(D)

# Fig. 5

Fig. 6

Vox-A

Vox-B

Vox-C

Vox-D

Vox-E

Fig.7A

Vox-A'

Vox-B'

Vox-C'

Vox-D'

Vox-E'

Fig.7B

# Fig.8

# Fig.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2567668

**Littérature non-brevet citée dans la description**

- **SHOJI MARUO ; OSAMU NAKAMURA ; SATOSHI KAWATA.** Three-dimensional microfabrication with two-photon-absorbed photopolymerization. *Opt. Lett.,* 1997, vol. 22, 132-134
- **LI.** Stereolithography with variable resolutions using optical filter with high contrast-gratings. *Al, J. Vac. Sci. Technol. B,* Novembre 2015, vol. 33 (6
- **YI et al.** using variable beam spot scanning to improve the SL process. *Rapid Prototyping Journal,* 2013, vol. 19 (2), 100-110
- **ANDRÉ J.C. ; MALAQUIN L. ; GUÉDON E.** Bio-printing ; où va-t-on. *Techniques de l'Ingénieur - ref. RE268 V1,* 2017, 23pp
- **CHUA C.K. ; YEONG N.Y.** Bio-printing: principles and applications. 2015
- **MORIMOTO Y. ; TAKEUCHI S.** 3D cell culture based on microfluidic technique to mimic living tissues. *Biomatter. Sci.,* 2013, (1), 257-264
- Industrial Cationic Polymerization: An Overview. **VAIRON, J.-P. ; SPASSKY, N.** Cationic Polymerizations. Marcel Dekker, 1996, 683-750
- **OSKAR NUYKEN ; STEPHEN D. PASK.** Ring-Opening Polymerization-An Introductory Review. *Polymers,* 2013, vol. 5, 361-403
- **M. RUBIN.** Optical properties of soda lime silica glasses. *Solar Energy Materials,* 1985, vol. 12, 275-288